(19) Europäisches Patentamt
European Patent Office
Office européen des brevets

(11) **EP 4 422 358 A1**

(12) **EUROPEAN PATENT APPLICATION**

(43) Date of publication:
**28.08.2024 Bulletin 2024/35**

(21) Application number: **23158108.3**

(22) Date of filing: **23.02.2023**

(51) International Patent Classification (IPC):
**H05K 1/02** (2006.01)   **H01L 23/373** (2006.01)
**H05K 1/03** (2006.01)

(52) Cooperative Patent Classification (CPC):
**H05K 1/0271; H01L 23/053; H01L 23/3735;**
**H01L 23/562;** H01L 23/24; H05K 1/0306;
H05K 2201/09145

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Infineon Technologies AG**
**85579 Neubiberg (DE)**

(72) Inventors:
• **HÖHN, Alexander**
**59494 Soest (DE)**

• **RIMBERT-RIVIERE, Charles**
**59494 Soest (DE)**

(74) Representative: **Westphal, Mussgnug & Partner,**
**Patentanwälte mbB**
**Werinherstraße 79**
**81541 München (DE)**

Remarks:
Amended claims in accordance with Rule 137(2) EPC.

(54) **SUBSTRATE**

(57)   A substrate comprises a dielectric insulation layer (11), a first metallization layer (111) arranged on a first surface (101) of the dielectric insulation layer (11), and a second metallization layer (112) arranged on a second surface (102) of the dielectric insulation layer (11), opposite the first surface (101). The dielectric insulation layer (11) comprises an outer edge (113) extending between the first surface (101) and the second surface (102), wherein the outer edge (113) of the dielectric insulation layer (11) comprises a plurality of first sections (A) and a plurality of second sections (B). Along each of the plurality of first sections (A), a difference ($diff_{12}$) between a first distance (d1) and a second distance (d2) has a first value (v), and along each of the plurality of second sections (B), the difference ($diff_{12}$) between the first distance (d1) and the second distance (d2) has a second value (w) that is different from the first value (v), wherein the first distance (d1) is a distance between the outer edge (113) of the dielectric insulation layer (11) and an outer edge (1113) of the first metallization layer (111), and the second distance (d2) is a distance between the outer edge (113) of the dielectric insulation layer (11) and an outer edge (1123) of the second metallization layer (112).

FIG 4

**Description**

TECHNICAL FIELD

The instant disclosure relates to a substrate, in particular to a substrate for a power semiconductor module arrangement.

BACKGROUND

Power semiconductor module arrangements often include at least one substrate arranged in a housing. A semiconductor arrangement including a plurality of controllable semiconductor elements (e.g., IGBTs, MOSFETs, HEMTs, etc.) may be arranged on each of the at least one substrate. Each substrate usually comprises a substrate layer (e.g., a ceramic layer), a first metallization layer deposited on a first side of the substrate layer, and a second metallization layer deposited on a second side of the substrate layer. The controllable semiconductor elements are mounted, for example, on the first metallization layer. The second metallization layer may be attached to a base plate. The size of the first metallization layer may be as large as possible in order to provide a large mounting surface for the semiconductor bodies and any other devices of the power semiconductor module arrangement. The size of the second metallization layer on the other hand may be chosen to be smaller than the size of the first metallization layer in order to reduce a size of the solder area when mounting the substrate to a base plate (or a heat sink), thereby reducing the risk of solder leak and/or solder splash. Similarly, it may however also be possible that the size of the second metallization layer is larger than the size of the first metallization layer for any other reasons. When a distance between the edge of the substrate layer and the edge of the second metallization layer is larger (or smaller) than a distance between the edge of the substrate layer and the edge of the first metallization layer, this is usually referred to as "pull-back". Such a pull-back, however, may increase the risk of cracks forming in the first and/or second metallization layer, especially when the metallization layers are heated to temperatures above defined threshold temperatures.

There is a need for a substrate that offers the advantages of a pull-back design while, at the same time, having a decreased risk of cracks forming in the first and/or second metallization layers.

SUMMARY

A substrate includes a dielectric insulation layer, a first metallization layer arranged on a first surface of the dielectric insulation layer, and a second metallization layer arranged on a second surface of the dielectric insulation layer, opposite the first surface. The dielectric insulation layer comprises an outer edge extending between the first surface and the second surface, wherein the outer edge of the dielectric insulation layer comprises a plurality of first sections and a plurality of second sections. Along each of the plurality of first sections, a difference between a first distance and a second distance has a first value, and along each of the plurality of second sections, the difference between the first distance and the second distance has a second value that is different from the first value, wherein the first distance is a distance between the outer edge of the dielectric insulation layer and an outer edge of the first metallization layer, and the second distance is a distance between the outer edge of the dielectric insulation layer and an outer edge of the second metallization layer.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

BRIEF DESCRIPTION OF THE DRAWINGS

Figure 1 is a cross-sectional view of a power semiconductor module arrangement.

Figure 2, including Figures 2A and 2B, schematically illustrates different cross-sectional views of a substrate.

Figure 3 is a top view of a substrate according to embodiments of the disclosure.

Figure 4 is a bottom view of a substrate according to further embodiments of the disclosure.

Figure 5 schematically illustrates a top view of one corner of a substrate according to embodiments of the disclosure.

Figure 6 is a bottom view of a substrate according to further embodiments of the disclosure.

Figure 7 is a bottom view of a substrate according to even further embodiment of the disclosure.

DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

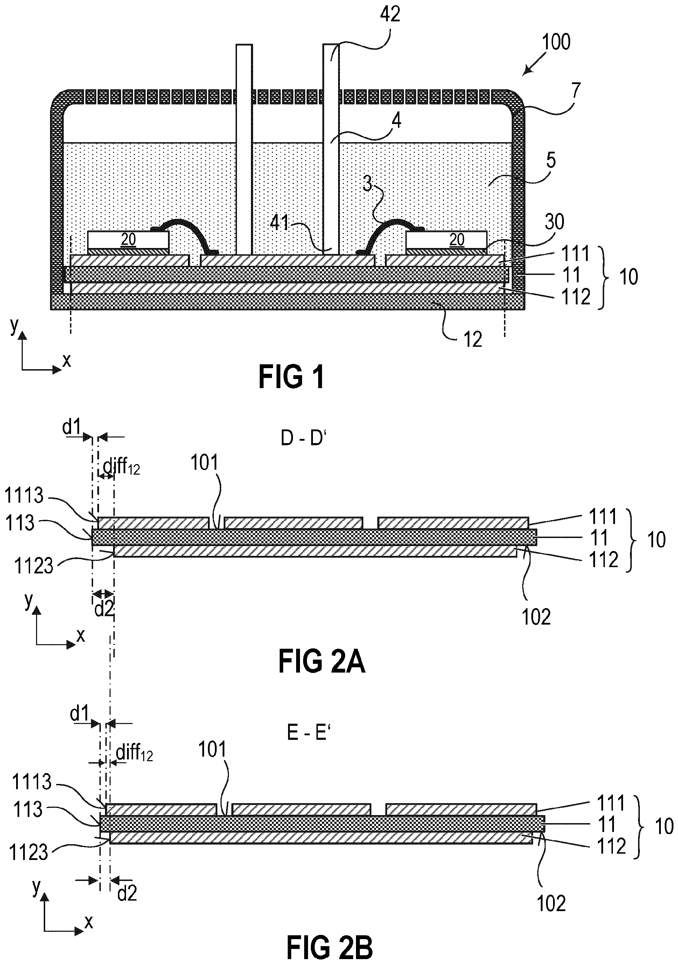

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: $Al_2O_3$, AlN, SiC, BeO or $Si_3N_4$. For instance, the substrate 10 may, e.g., be a Direct Copper Bonding (DCB) substrate, a Direct Aluminum Bonding (DAB) substrate, or an Active Metal Brazing (AMB) substrate. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This, however, is only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7. It is also possible that the substrate 10 itself forms a ground surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connection elements 3 such as, e.g., bonding wires or bonding ribbons. Electrical connections 3 may also include connection plates, conductor rails, or connection clips, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example. According to other examples, it is also possible that the second metallization layer 112 is a structured layer.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the terminal elements 4 protrudes out of the housing 7. The terminal elements 4 may be electrically contacted from the outside at their respective second ends 42. A first part of the terminal elements 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted. The terminal elements 4 illustrated in Figure 1, however, are only examples. Terminal elements 4 may be implemented in any other way and may be arranged anywhere within the housing 7. For example, one or more terminal elements 4 may be arranged close to or adjacent to the sidewalls of the housing 7. Terminal elements 4 could also protrude through the sidewalls of the housing 7 instead of through the cover. The first end 41 of a terminal element 4 may be electrically and mechanically connected to the substrate 10 by an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. The first end 41 of a terminal element 4 may also be electrically coupled to the substrate 10 via one or more electrical connections 3, for example.

The power semiconductor module arrangement 100 may further include an encapsulant 5. An encapsulant 5 may consist of or include a silicone gel or may be a rigid molding compound, for example. The encapsulant 5 may at least partly fill the interior of the housing 7, thereby covering the components and electrical connections that are arranged on the substrate 10. The terminal elements 4 may be partly embedded in the encapsulant 5. At least their second ends 42, however, are not covered by the encapsulant 5 and protrude from the encapsulant 5 through the housing 7 to the outside of the housing 7. The encapsulant 5 is configured to protect the components and electrical connections of the power semiconductor module 100, in particular the components arranged on the substrate 10 inside the housing 7, from certain environmental conditions and mechanical damage.

In the example illustrated in Figure 1, a size of the second metallization layer 112 equals a size of the first metallization layer 111. That is, a distance between an outer edge of the dielectric insulation layer 11 and an outer edge of the first metallization layer 111 equals a distance between the outer edge of the dielectric insulation layer 11 and an outer edge of the second metallization layer 112 along the entire circumference of the dielectric insulation layer 11. Or, in other words, the outer edge of the first metallization layer 111 is aligned with the outer edge of the second metallization layer 112, as is emphasized by the dashed lines in Figure 1.

Usually, the size of the first metallization layer 111 is as large as possible in order to provide a large mounting surface for the semiconductor bodies 20 and any other devices (e.g., terminal elements 4) of the power semiconductor module arrangement. The size of the second metallization layer 112 on the other hand may be chosen to be smaller than the size of the first metallization layer 111 in order to reduce a size of the solder area when mounting the substrate 10 to a base plate 12, thereby reducing the risk of solder leak and/or solder splash. That is, the distance $d1$ between the outer edge 113 of the dielectric insulation layer 11 and the outer edge 1113 of the first metallization layer 111 may be less than the distance $d2$ between the outer edge 113 of the dielectric insulation layer 11 and the outer edge 1123 of the second metallization layer 112 along the entire circumference of the dielectric insulation layer 11, as is exemplarily illustrated in the cross-sectional view of Figure 2A. Similarly, for any reasons, it may however also be possible that the size of the second metallization layer 112 is larger than the size of the first metallization layer 111 such that the distance $d1$ between the outer edge 113 of the dielectric insulation layer 11 and the outer edge 1113 of the first metallization layer 111 is greater than the distance $d2$ between the outer edge 113 of the dielectric insulation layer 11 and the outer edge 1123 of the second metallization layer 112 along the entire circumference of the dielectric insulation layer 11 (not specifically illustrated).

When a distance $d2$ between the outer edge 113 of the dielectric insulation layer 11 and the outer edge 1123 of the second metallization layer 112 is larger (or smaller) than a distance $d1$ between the outer edge 113 of the dielectric insulation layer 11 and the outer edge 1113 of the first metallization layer 111, this is usually referred to as "pull-back". Such a pull-back, however, may increase the risk of cracks forming in the first and/or second metallization layers 111, 112, especially when the metallization layers 111, 112 are heated to temperatures above defined threshold temperatures. This is, because the pull-back may result in high tensions in the dielectric insulation layer 11. Such tensions may be further influenced by a temperature of the substrate 10 due to the so-called bi-metallic effect (increased tension at higher temperatures).

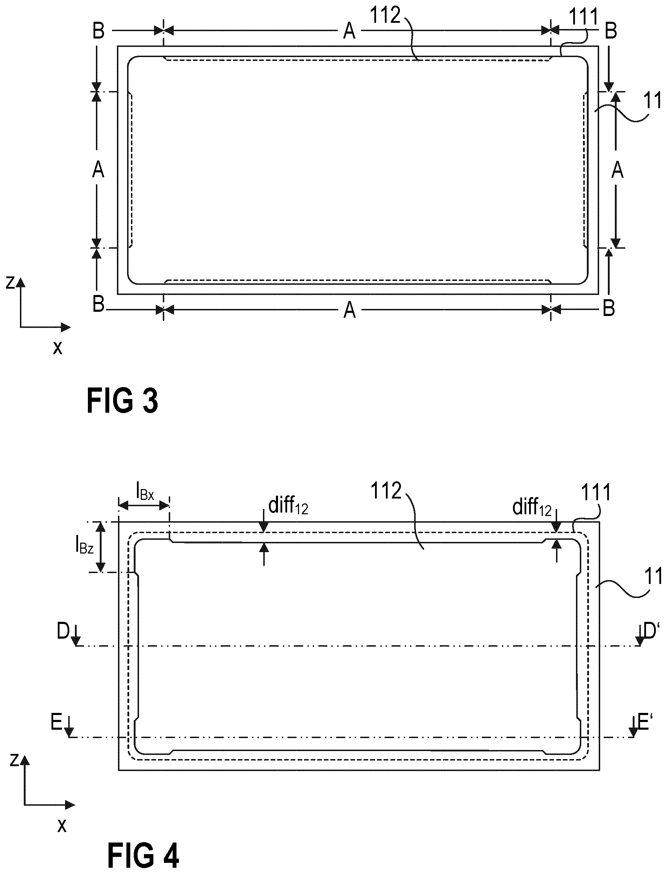

Now referring to Figure 2, different cross-sectional views of a substrate 10 according to embodiments of the disclosure are schematically illustrated. The substrate 10 comprises a dielectric insulation layer 11, a first metallization layer 111 arranged on a first surface 101 of the dielectric insulation layer 11, and a second metallization layer 112 arranged on a second surface 102 of the dielectric insulation layer 11, opposite the first surface 101. The dielectric insulation layer 11 comprises an outer edge 113 extending between the first surface 101 and the second surface 102, wherein the outer edge 113 of the dielectric insulation layer 11 comprises a plurality of first sections A and a plurality of second sections B (see, e.g., top view of substrate illustrated in Figure 3). Along each of the plurality of first sections A, a difference $diff_{12}$ between a first distance $d1$ and a second distance $d2$ has a first value $v$, and along each of the plurality of second sections B, the difference $diff_{12}$ between the first distance $d1$ and the second distance $d2$ has a second value $w$ that is different from the first value ($v \neq w$). The first distance $d1$ is a distance between the outer edge 113 of the dielectric insulation layer 11 and an outer edge 1113

of the first metallization layer 111, and the second distance d2 is a distance between the outer edge 113 of the dielectric insulation layer 11 and an outer edge 1123 of the second metallization layer 112.

That is, along the first sections A

$$diff_{12} = |d1 - d2| = v,$$

and along the second sections B

$$diff_{12} = |d1 - d2| = w,$$

wherein, $v \neq w$.

According to one embodiment of the disclosure, the following may apply: $v > w$ (first value v greater than second value w).

The first sections A may be referred to as pull-back sections or full pull-back sections, and the second sections B may be referred to as no pull-back sections or reduced pull-back sections, for example. By providing sections with a full pull-back as well as sections with a reduced or even no pull-back, the advantages of the pull-back design are combined with the advantages of a no-pullback design or at least a reduced pull-back design. That is, in the second sections B, the tensions arising in the dielectric insulation layer 11 may be significantly reduced while still providing the advantages of the pull-back design along the first sections A. Top and bottom views of substrates 10 according to embodiments of the disclosure are schematically illustrated in Figures 3 (no pull-back design in second sections B) and 4 (reduced pull-back design in second sections B). Figure 3 schematically illustrates a top view in which the first metallization layer 111 is visible, while the second metallization layer 112 (illustrated in dashed lines) is concealed by the first metallization layer 111 and the dielectric insulation layer 11. Figure 4 schematically illustrates a bottom view of a substrate 10 in which the second metallization layer 112 is visible, while the first metallization layer 111 (illustrated in dashed lines) is concealed by the second metallization layer 112 and the dielectric insulation layer 11. Figure 2A schematically illustrates a cross-sectional view along a section line D - D', and Figure 2B schematically illustrates a cross-sectional view along a section line E - E' of the substrate 10 as illustrated in Figure 4.

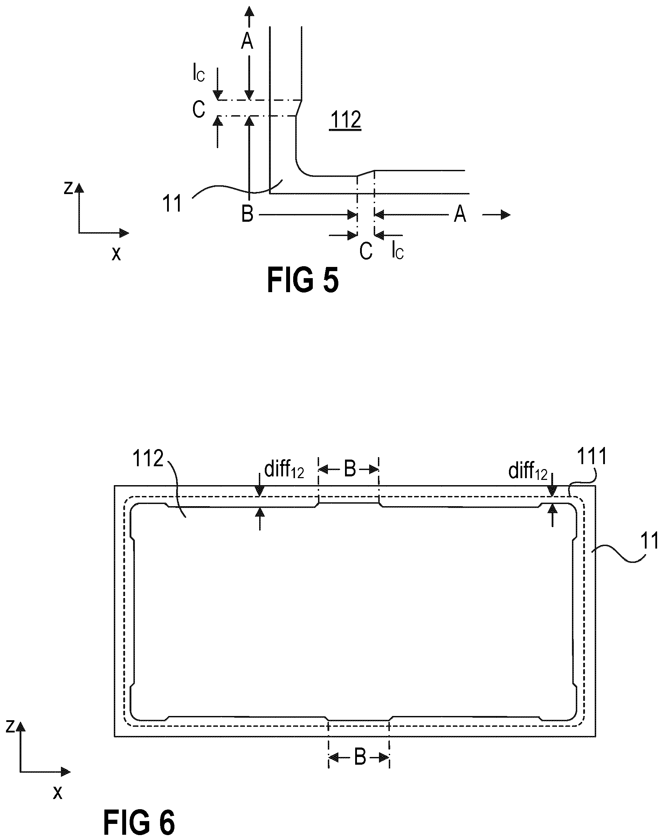

As can be seen in Figures 3 and 4, for example, the first sections A and the second sections B are arranged alternatingly along the circumference of the dielectric insulation layer 11. The substrate 10 may comprise at least two first sections A and at least two second sections B, for example. The number of first sections A generally equals the number of second sections B. The dielectric insulation layer 11 may have a rectangular shape, and each of the second sections B may be arranged at a different corner of the dielectric insulation layer 11, for example, as is schematically illustrated in Figures 3 and 4. This, however, is only an example. Alternatively or additionally, second sections B may also be arranged anywhere along the sides of the dielectric insulation layer 11, as is schematically illustrated in Figure 6. A length of a second section B extending along a side of the dielectric insulation layer 11, however, is less than the length of the respective side of the dielectric insulation layer 11. For example, a length of a second section B extending along a side of the dielectric insulation layer 11 may be less than 50% or even less than 30% of the respective side of the dielectric insulation layer 11.

The substrate 10 illustrated in Figure 6 comprises one additional second section B along each of the longitudinal sides of the dielectric insulation layer 11 (a rectangular dielectric insulation layer 11 generally comprises two longitudinal sides extending in parallel to each other, and two narrow sides extending in parallel to each other and perpendicular to the longitudinal sides). Additionally or alternatively, second sections B may be arranged anywhere along the circumference of the dielectric insulation layer 11. It is also possible that two or more second sections B are arranged along one side of the dielectric insulation layer 11. Generally, second sections B with a reduced pull-back or no pull-back may be arranged in those sections along the circumference of the dielectric insulation layer 11 that are particularly sensitive and prone to cracks forming in the first and/or second metallization layers 111, 112.

The corners of the metallization layers 111, 112, for example, may be particularly sensitive and prone to the formation of cracks in a pull-back design. With the second sections B extending along the corners of the dielectric insulation layer 11, as illustrated in Figures 3 and 4, the formation of cracks in the area of the corners of the metallization layers 111, 112 may be significantly reduced or even entirely avoided. Each of the second sections B may extend from the respective corner in a first horizontal direction x and in a second horizontal direction z that is perpendicular to the first horizontal direction x (see, e.g., Figure 4). According to one embodiment of the disclosure, a length $l_{Bx}$ of each of the second sections B in the first horizontal direction x may be less than 15mm (Millimeters), and a length $l_{Bz}$ of each of the second sections B in the second horizontal direction z is less than 15mm. According to another embodiment of the disclosure, the length $l_{Bx}$ of each of the second sections B in the first horizontal direction x may be less than 5mm, and the length $l_{Bz}$ of each of the second sections B in the second horizontal direction z may be less than 5mm. According to an even further embodiment of the disclosure, the length $l_{Bx}$ of each of the second sections B in the first horizontal direction x may be less than 3mm, and the length $l_{Bz}$ of each of the second sections B in the second horizontal direction z may be less than 3mm. The length $l_{Bx}$ of each of the second sections B in the first horizontal direction x may equal the length $l_{Bz}$ of each of the second sections B in the second horizontal direction z. It is, however, also possible that the length $l_{Bx}$ of a second section B in the first horizontal direction x differs from the length $l_{Bz}$ of the respective second sections B in the second horizontal direction z.

The first value v may be between 0.2mm and 1.2mm (millimeters), for example. That is, $0.2mm \leq v \leq 1.2mm$, for example. The second value w may be 50% of the first value v, or less. That is, $w \leq 0.5 * v$, for example. When $w = 0.5 * v$, the pull-back is already significantly decreased, thereby also decreasing the tension along the second sections B. By further reducing the pull-back (e.g., $0 < w < 0.5 * v$), the tension may be decreased even further. If $w = 0$, the respective second section B is a no pull-back section, and the tension may be reduced to a minimum. A no-pull back region, however, generally does not profit from the advantages of a pull-back at all. Whether the second sections B are implemented as reduced pull-back sections or no pull-back sections generally depends on the overall design of the power semiconductor module arrangement and the application it is used for. In some cases, reduced pull-back sections may be preferable, while in other cases no pull-back sections may be more appropriate.

Now referring to Figure 5, the dielectric insulation layer 11 may further comprise a plurality of third sections C, wherein each third section C is arranged between a first section A and a second section B. Along each of the third sections C, the difference $\text{diff}_{12}$ gradually transitions from the first value v to the second value w. That is, a transition between the first sections A and the second sections B may be comparably smooth. A length lc of a third section C (distance between first section A and second section B) may be between 0.1 and 5mm (millimeters), for example. It is, however, also possible that the third sections C be omitted. That is, there may be a hard edge between the first sections A and the second sections B. A smooth transition between the first sections A and the second sections B by means of the third sections C, however, may further decrease the tension in the dielectric insulation layer 11.

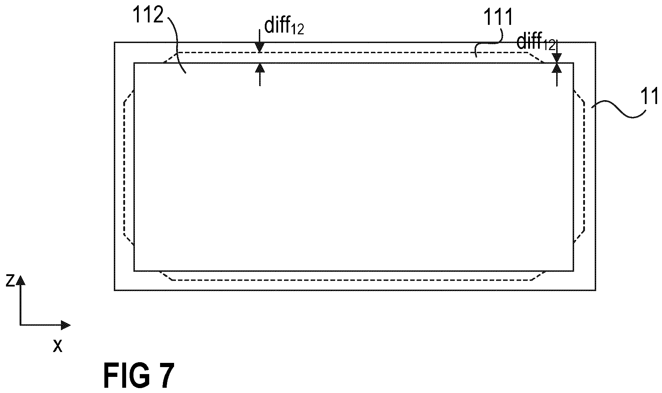

In the examples illustrated in Figures 3 to 6, the reduced pull-back or no pull-back sections (second sections) are implemented by decreasing the distance d2 between the outer edge 113 of the dielectric insulation layer and the outer edge 1123 of the second metallization layer 112. That is, the second metallization layer 112 comprises bulges or projections in the areas of the second sections B. It is, however, generally also possible to instead increase the distance d1 between the outer edge 113 of the dielectric insulation layer 11 and the outer edge 1113 of the first metallization layer 111, as is schematically illustrated in Figure 7. That is, the first metallization layer 111 (as outlined in a dashed line in the bottom view of Figure 7) may comprise dents or indentations in the areas of the second sections B.

**Claims**

1. A substrate (10) comprises,

   a dielectric insulation layer (11);
   a first metallization layer (111) arranged on a first surface (101) of the dielectric insulation layer (11); and
   a second metallization layer (112) arranged on a second surface (102) of the dielectric insulation layer (11), opposite the first surface (101), wherein the dielectric insulation layer (11) comprises an outer edge (113) extending between the first surface (101) and the second surface (102), wherein the outer edge (113) of the dielectric insulation layer (11) comprises a plurality of first sections (A) and a plurality of second sections (B),
   wherein along each of the plurality of first sections (A), a difference ($\text{diff}_{12}$) between a first distance (d1) and a second distance (d2) has a first value (v),
   wherein along each of the plurality of second sections (B), the difference ($\text{diff}_{12}$) between the first distance (d1) and the second distance (d2) has a second value (w) that is different from the first value (v), and
   wherein the first distance (d1) is a distance between the outer edge (113) of the dielectric insulation layer (11) and an outer edge (1113) of the first metallization layer (111), and the second distance (d2) is a distance between the outer edge (113) of the dielectric insulation layer (11) and an outer edge (1123) of the second metallization layer (112).

2. The substrate (10) of claim 1, wherein the first sections (A) and the second sections (B) are arranged alternatingly along the circumference of the dielectric insulation layer (11).

3. The substrate (10) of claim 1 or 2, wherein the dielectric insulation layer (11) has a rectangular shape, and each of the second sections (B) is arranged at a different corner of the dielectric insulation layer (11).

4. The substrate (10) of claim 3, wherein each of the second sections (B) extends from the respective corner in a first horizontal direction (x) and in a second horizontal direction (z) that is perpendicular to the first horizontal direction (x).

5. The substrate (10) of claim 4, wherein

   a length ($l_{Bx}$) of each of the second sections (B) in the first horizontal direction (x) is less than 15mm, and

a length ($l_{Bz}$) of each of the second sections (B) in the second horizontal direction (z) is less than 15mm.

6. The substrate (10) of claim 5, wherein

the length ($l_{Bx}$) of each of the second sections (B) in the first horizontal direction (x) is less than 5mm, and
the length ($l_{Bz}$) of each of the second sections (B) in the second horizontal direction (z) is less than 5mm.

7. The substrate (10) of claim 6, wherein

the length ($l_{Bx}$) of each of the second sections (B) in the first horizontal direction (x) is less than 3mm, and
the length ($l_{Bz}$) of each of the second sections (B) in the second horizontal direction (z) is less than 3mm.

8. The substrate (10) of any of claims 5 to 7, wherein the length ($l_{Bx}$) of each of the second sections (B) in the first horizontal direction (x) equals the length ($l_{Bz}$) of each of the second sections (B) in the second horizontal direction (z).

9. The substrate (10) of any of the preceding claims, wherein the first value (v) is between 0.2mm and 1.2mm.

10. The substrate (10) of any of the preceding claims, wherein the first value (v) is greater than the second value (w).

11. The substrate (10) of claim 10, wherein the second value (w) is 50% of the first value (v) or less.

12. The substrate (10) of claim 11, wherein the second value (w) is zero.

13. The substrate (10) of any of the preceding claims, wherein the dielectric insulation layer (11) further comprises a plurality of third sections (C), wherein each third section (C) is arranged between a first section (A) and a second section (B), and wherein along each of the third sections (C), the difference ($diff_{12}$) gradually transitions from the first value (v) to the second value (w).

14. The substrate (10) of claim 13, wherein a length ($lc$) of each of the third sections (C) is between 0.1mm and 5mm.

**Amended claims in accordance with Rule 137(2) EPC.**

1. A substrate (10) comprises,

a dielectric insulation layer (11);
a first metallization layer (111) arranged on a first surface (101) of the dielectric insulation layer (11); and
a second metallization layer (112) arranged on a second surface (102) of the dielectric insulation layer (11), opposite the first surface (101), wherein the dielectric insulation layer (11) comprises an outer edge (113) extending between the first surface (101) and the second surface (102), wherein the outer edge (113) of the dielectric insulation layer (11) comprises a plurality of first sections (A) and a plurality of second sections (B),
wherein the dielectric insulation layer (11) has a rectangular shape, and each of the second sections (B) is arranged at a different corner of the dielectric insulation layer (11),
wherein each of the second sections (B) extends from the respective corner in a first horizontal direction (x) and in a second horizontal direction (z) that is perpendicular to the first horizontal direction (x),
wherein along each of the plurality of first sections (A), a difference ($diff_{12}$) between a first distance (d1) and a second distance (d2) has a first value (v),
wherein along each of the plurality of second sections (B), the difference ($diff_{12}$) between the first distance (d1) and the second distance (d2) has a second value (w) that is different from the first value (v), wherein the first value (v) is greater than the second value (w), and
wherein the first distance (d1) is a distance between the outer edge (113) of the dielectric insulation layer (11) and an outer edge (1113) of the first metallization layer (111), and the second distance (d2) is a distance between the outer edge (113) of the dielectric insulation layer (11) and an outer edge (1123) of the second metallization layer (112).

2. The substrate (10) of claim 1, wherein the first sections (A) and the second sections (B) are arranged alternatingly along the circumference of the dielectric insulation layer (11).

3. The substrate (10) of claim 1 or 2, wherein

a length ($l_{Bx}$) of each of the second sections (B) in the first horizontal direction (x) is less than 15mm, and
a length ($l_{Bz}$) of each of the second sections (B)

in the second horizontal direction (z) is less than 15mm.

4. The substrate (10) of claim 3, wherein

   the length ($l_{Bx}$) of each of the second sections (B) in the first horizontal direction (x) is less than 5mm, and
   the length ($l_{Bz}$) of each of the second sections (B) in the second horizontal direction (z) is less than 5mm.

5. The substrate (10) of claim 4, wherein

   the length ($l_{Bx}$) of each of the second sections (B) in the first horizontal direction (x) is less than 3mm, and
   the length ($l_{Bz}$) of each of the second sections (B) in the second horizontal direction (z) is less than 3mm.

6. The substrate (10) of any of claims 3 to 5, wherein the length ($l_{Bx}$) of each of the second sections (B) in the first horizontal direction (x) equals the length ($l_{Bz}$) of each of the second sections (B) in the second horizontal direction (z).

7. The substrate (10) of any of the preceding claims, wherein the first value (v) is between 0.2mm and 1.2mm.

8. The substrate (10) of any of the preceding claims, wherein the second value (w) is 50% of the first value (v) or less.

9. The substrate (10) of claim 8, wherein the second value (w) is zero.

10. The substrate (10) of any of the preceding claims, wherein the dielectric insulation layer (11) further comprises a plurality of third sections (C), wherein each third section (C) is arranged between a first section (A) and a second section (B), and wherein along each of the third sections (C), the difference ($diff_{12}$) gradually transitions from the first value (v) to the second value (w).

11. The substrate (10) of claim 10, wherein a length (lc) of each of the third sections (C) is between 0.1mm and 5mm.

FIG 1

D - D'

FIG 2A

E - E'

FIG 2B

FIG 3

FIG 4

**FIG 5**

**FIG 6**

FIG 7

Europäisches
Patentamt

European
Patent Office

Office européen
des brevets

## EUROPEAN SEARCH REPORT

Application Number

EP 23 15 8108

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 40 04 844 C1 (ABB IXYS SEMICONDUCTOR GMBH [DE]) 3 January 1991 (1991-01-03) | 1-9,13, 14 | INV. H05K1/02 |
| Y | * the whole document * | 1-14 | H01L23/373 |
| Y | US 5 403 651 A (MIYAGI MASAHIDE [JP]) 4 April 1995 (1995-04-04) * column 2, lines 39-57 * * column 4, lines 4-35; figures 1,2,4 * | 1-14 | ADD. H05K1/03 |

TECHNICAL FIELDS
SEARCHED     (IPC)

H05K
H01L

The present search report has been drawn up for all claims

| Place of search | Date of completion of the search | Examiner |
|---|---|---|
| The Hague | 8 August 2023 | Degroote, Bart |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

..........................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 15 8108

This annex lists the patent family members relating to the patent documents cited in the above-mentioned European search report.
The members are as contained in the European Patent Office EDP file on
The European Patent Office is in no way liable for these particulars which are merely given for the purpose of information.

08-08-2023

| Patent document cited in search report | | | Publication date | Patent family member(s) | Publication date |
|---|---|---|---|---|---|
| DE 4004844 | C1 | | 03-01-1991 | NONE | |
| US 5403651 | A | | 04-04-1995 | NONE | |

EPO FORM P0459